# EUROPÄISCHE PATENTANMELDUNG

(11) **EP 0 786 792 A1**
(43) Veröffentlichungstag der Anmeldung: **30.07.1997**
(21) Anmeldenummer: 96115192.5
(22) Anmeldetag: 21.09.1996
(51) Int. Cl.: H01J 37/32, H01J 37/317, C23C 14/48

(54) **Verfahren zur Implantation von Ionen in leitende bzw. halbleitende Werkstücke mittels Plasmaimmersionsionenimplantation und Implantationskammer zur Durchführung des Verfahrens**

(30) Priorität: 19.10.1995 DE 19538903
(71) Anmelder: Forschungszentrum Rossendorf e.V., 01474 Schönfeld-Weissig (DE)
(72) Erfinder: Brutscher, Jörg, Dr., 01855 Sebnitz (DE); Günzel, Reinhard, Dr., 01277 Dresden (DE)

(57) **Zusammenfassung**

Der Erfindung betrifft ein Verfahren zur Implantation von Ionen in leitende bzw. halbleitende Werkstücke mittels Plasmaimmersionsimplantation ( PIII ) das ohne aufwendige Hochspannungspulser zu guten Implantationsergebnissen führt.
Das erfindungsgemäße Verfahren besteht darin, daß an die zu implantierenden Werkstücke eine DC-Hochspannung (Gleichspannung > 5kV) angelegt und das Plasma gepulst wird.
Zur Erzeugung des Plasmas wird vorteilhaft eine Anordnung mit geheizten Filamenten oder eine ECR-Quelle eingesetzt. Das Plasma wird gepulst, indem die Bogenspannung an den Filamenten gepulst wird, oder aber der Mikrowellengenerator der ECR-Quelle im Pulsbetrieb betrieben wird.
Um zu verhindern, daß das das vom auf Hochspannung liegenden Werkstück ausgehende elektrische Feld bis auf die Ionenquelle durchgreift, dort den Austritt von Elektronen unterdrückt und die Zündung des Plasmas erschwert, wird die Plasmaquelle geometrisch so angeordnet bzw. gegenüber der Hochspannung abgeschirmt, daß der Durchgriff der Hochspannung auf die Plasmaquelle minimal ist. Konkret kann dies z.B. dadurch erfolgen, daß die Plasmaquelle an die Implantationskammer mit einem genügend tiefen Hals angeflanscht wird, oder daß zwischen Plasmaquelle und Werkstück in Abständen von einigen cm dünne geerdete Drähte gespannt werden.

## Beschreibung

Die konventionelle Methode zur Implantation von Ionen in Werkstücke erfolgt mit Hilfe eines Ionenbeschleunigers, d.h. aus einer auf Hochspannungspotential liegenden Plasmaquelle werden Ionen extrahiert, beschleunigt und mit Hilfe eines Strahlführungssystems auf ein Werkstück gelenkt [ US-PS 4,234,797 ]. Diese Technik ist relativ aufwendig und teuer. Eine Weiterentwicklung hin zu einer weniger aufwendigen Anordnung ist die Plasmaimmersionsimplantation (PIII) bzw. Plasma source ion implantation (PSII, PII) [J.R. Conrad and J.R. Radke, J.Appl.Phys. 62(11), Dezember 1987 p.4591 14; G.A. Collins and J.Tendys, Plasma Sources Sci. Technol. 3 (1994) 10-18]. Hier wird das Werkstück direkt in ein Plasma gebracht und pulsierend mit Hochspannung beaufschlagt. Als Werkstück kommen Metalle, aber auch Halbleiter in Frage. Die Ionen werden direkt aus dem Plasma extrahiert und in einer Raumladungsschicht auf das Werkstück beschleunigt. Um die Randschicht und damit die Stoßverluste in der Randschicht klein zu halten, muß eine relativ hohe Plasmadichte verwendet werden. Um die aus der damit gegebenen hohen Stromdichte resultierende thermische Belastung gering zu halten, muß das Verfahren gepulst betrieben werden, d.h. in den bisher gebauten Anlagen wird das Plasma kontinuierlich erzeugt und die Hochspannung gepulst. Eine einfache Möglichkeit, Hochspannungspulse zu erzeugen ist, einen Kondensator über das Plasma zu entladen, was aber eine breite Ionenenergieverteilung zur Folge hat. Um lastunabhängig rechteckige Hochspannungspulse zu erzeugen, wird meist eine Schaltung mit einer Hochspannungstetrode verwendet. Leistungsfähiger, aber noch aufwendiger sind Schaltungen mit einem Crossatron. Zur Erzeugung des Plasmas werden ECR (Mikrowellen)-Quellen, HF (13,5 MHz)- Quellen oder Plasmaquellen mit heißen Filamenten [ US-PS 4,764,394 ] und Magneteinschluß betrieben. Diese Quellen können sich innerhalb der Implantationskammer befinden, man kann aber auch eine oder mehrere Quellen an die Implantationskammer anflanschen. Die Quellen werden durchweg DC betrieben.
Die Bereitstellung der benötigten lastunabhängigen Hochspannungspulse ist nicht trivial. DC-Hochspannungsversorgungen sind zwar kommerziell leicht erhältlich, aber Pulsgeneratoren in dem für die PIII erforderlichen Leistungsbereich sind meist Sonderanfertigungen und deshalb sehr teuer. Der Hochspannungspulser ist daher einer der wesentlichen Kostenfaktoren beim Bau einer Plasmaimmersionsanlage.

Der Erfindung liegt danach die Aufgabe zugrunde, ein Implantationsverfahren sowie eine entsprechende Einrichtung zu schaffen, die ohne aufwendige Hochspannungspulser zu befriedigenden Implantationsergebnissen führt.

Erfindungsgemäß wird diese Aufgabe durch das in den Patentansprüchen dargelegte Verfahren zur plasmagepulsten PIII sowie die zu dessen Durchführung umgestaltete Plasmaquelle gelöst.

Zur Erzeugung des Plasmas wird vorteilhaft eine Anordnung mit geheizten Filamenten oder eine ECR-Quelle eingesetzt. Das Plasma wird gepulst, indem die Bogenspannung an den Filamenten gepulst wird, oder aber der Mikrowellengenerator der ECR-Quelle pulsierend betrieben wird.
Ein Problem dieser Verfahrensweise besteht darin, daß das elektrische Feld vom Werkstück bis auf die Ionenquelle durchgreift, den Austritt von Elektronen unterdrückt und die Zündung des Plasmas erschwert. Dieses Problem wurde mit einer konstruktiven Änderung der Implantationskammer erfindungsgemäß dadurch gelöst, daß die Plasmaquelle geometrisch so angeordnet bzw. gegenüber der Hochspannung abgeschirmt ist, daß der Durchgriff der Hochspannung auf die Plasmaquelle minimal ist. Konkret kann dies z.B. dadurch erfolgen, daß die Plasmaquelle an die Implantationskammer mit einem genügend tiefen Hals angeflanscht wird, oder daß zwischen Plasmaquelle und Werkstück in Abständen von einigen cm dünne geerdete Drähte gespannt werden. Diese Drähte schirmen die Quelle hinreichend vom elektrischen Feld ab, haben dann aber nach der Zündung keinen Einfluß mehr auf das Plasma. Die Plasmapulse werden bei höheren Spannungen möglichst kurz (z.B. 50 µs) gewählt, um die thermische Belastung im Puls gering zu halten. Parallel zum Hochspannungsnetzteil befindet sich ein Kodensator, um die pulsformige Belastung abzupuffern. Zwischen Netzteil und Hochspannungsdurchführung an der Kammer befindet sich noch ein Widerstand, um bei Bogenzündungen am Werkstück den Durchschlagsstrom zu dämpfen.

Der Vorteil der erfindungsgemäßen Plasmapulsimplantation besteht darin, Plasmaimmersionsimplantation betreiben zu können, ohne auf einen teuren Hochspannungspulser angewiesen zu sein. Das Pulsen der Bogenspannung von ca. 200 V an den Filamenten ist wesentlich weniger aufwendig und läßt sich mit einem Leistungs-MOSFET gut realisieren. Außerdem fallen die Ionenenergieverluste in der Anstiegs- und in der Abfallphase des Hochspannungspulses weg.

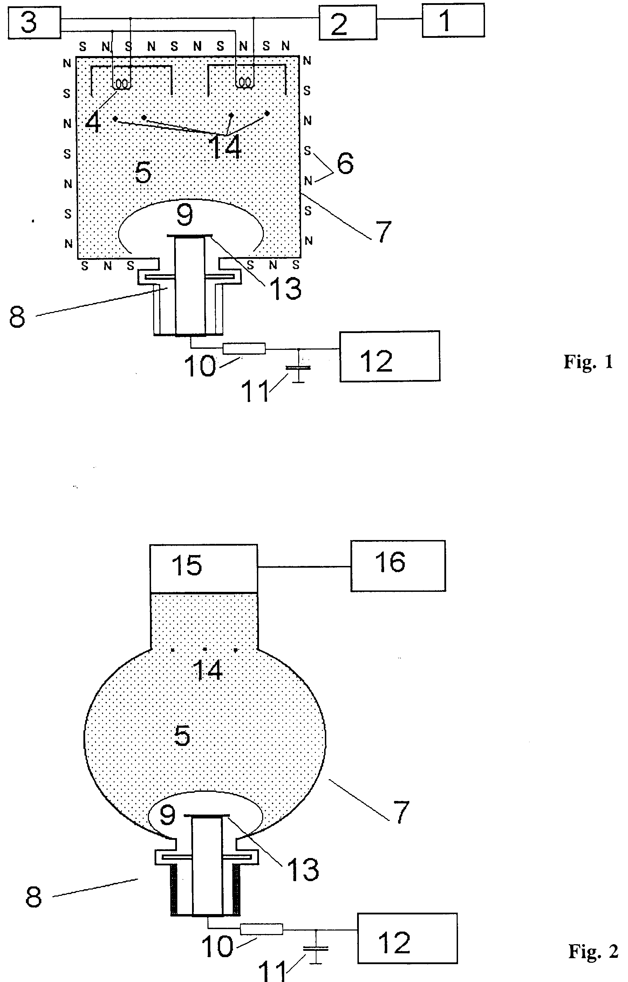

Die Erfindung wird nachfolgend anhand zweier Ausführungsbeispiele weiter erläutert, in der zugehörigen Figur 1 ist eine erfindungsgemäß gestaltete Einrichtung mit Einsatz einer Plasma-Ionenquelle mit heißen Filamenten, in Figur 2 eine Implantationskammer mit ECR-Ionenquelle dargestellt.

Das zu implantierende Werkstück wird in der Implantationskammer (7) an der Probenhalterung (13) befestigt, die sich am Ende der Hochspannungsdurchführung (8) befindet. Nach Abpumpen der Luft und Einstellen eines Gasdruckes von ca. 0.2 Pa ( z.B. N₂ ) wird die negative Hochspannung (-35 kV) an die Hochspannungsdurchführung (8) angeschaltet. Zwischen Hochspannungsnetzteil (12) und Durchführung (8) befindet sich ein Widerstand (10) von ca. 1...5 kΩ, um die Auswirkungen von Bogenzündungen abzudämpfen. Außerdem ist das Hochspannungsnetzteil gegen die impulsartige Stromentnahme noch mit einem Kondensator (11) von einigen nF abgepuffert. Eine Magnetfeldanordnung (6) in der Nähe der Filamente sorgt dafür, daß es auch bei niedrigen Drucken noch möglich ist, ein Plasma zu zünden. In der Nähe des auf Hochspannungspotential liegenden Werkstückes sind die Magnetfelder gering, so daß der Zünddruck für eine Glimmentladung gut oberhalb des Arbeitsdruckes liegt. Die Filamente (4) werden über einen Regeltrafo (3) mit Heizstrom versorgt. Zwischen den Filamenten (4) und der Hochspannungsdurchführung (8) befinden sich noch einige dünne Drähte (14) um den Durchgriff des elektrischen Feldes auf die Filamente (4) zu reduzieren. Das Plasma (5) wird gezündet, indem die Bogenspannungsversorgung (1) mit einem MOSFET-Schalter (2) an die Filamente (4) geschaltet wird. Die Bogenspannung von ca. 200 V wird für ca. 50 µs mit einer Wiederholrate von 50 Hz eingeschaltet. Einige µs nach Einschalten der Bogenspannung bildet sich eine Plasmawolke (5) aus, die sich in der Implantationskammer (7) ausbreitet. Die Plasmadichte (22) steigt nach der Zündung stetig an, vor Erreichen des Gleichgewichtszustandes wird die Bogenspannung aber wieder abgeschaltet und das Plasma zerfällt mit einer Zeitkonstante von einigen 100 µs. Die Ionen werden in einer Raumladungschicht (9) vor dem Werkstück auf das Werkstück zu beschleunigt. Die Ausdehnung der Raumladungsschicht (23) hängt von Plasmadichte und Spannung am Werkstück ab.

Bei der in Fig. 2 dargestellten Implantationskammer wird anstelle der Plasmaerzeugung mit heißen Filamenten das Plasma mit einer ECR-Quelle (15) erzeugt. Eine solche Quelle besteht bekanntermaßen aus einer Mikrowelleneinkopplung und einem Magneten. Entsprechend der Erfindung wird hier der Mikrowellengenerator (16) gepulst betrieben. Das Plasma zündet in der Nähe der Mikrowelleneinkopplung, wo das Magnetfeld die ECR-Bedingungen erfüllt. Auch hier werden zwischen der Plasmaquelle (15) und der eigentlichen Implantatioskammer einige dünne Drähte (14) angeordnet, um den Durchgriff des von der auf DC-Hochspannung liegenden Probe ausgehenden elektrischen Feldes auf die Plasmaquelle zu reduzieren, und damit die ungestörte Zündung des Plasmas zu ermöglichen. Eine weitere Möglichkeit zur Realisierung dieser Abschirmfunktion besteht darin, die Plasmaquelle in einen genügend tiefen Flansch einzubauen. Die weitere Funktion der Einrichtung mit ECR-Quelle ist analog der für die Quelle mit heißen Filamenten beschriebenen.

## Patentansprüche

1. Verfahren zur Implantation von Ionen in leitende bzw. halbleitende Werkstücke mittels Plasmaimmersionsionenimplantation ( PIII ), dadurch gekennzeichnet, daß an die zu implantierenden Werkstücke eine DC-Hochspannung (Gleichspannung > 5kV) angelegt und das Plasma gepulst wird.

2. Verfahren nach Anspruch 1 bei dem eine Plasmaquelle mit heißen Filamenten eingesetzt wird, dadurch gekennzeichnet, daß das Plasma durch Pulsation der Bogenspannung an den Filamenten gepulst wird.

3. Verfahren nach Anspruch 1 bei dem eine ECR-Plasmaquelle eingesetzt wird, dadurch gekennzeichnet, daß das Plasma durch Pulsation des Mikrowellengenerators gepulst wird.

4. Implantationskammer zur Durchführung des Verfahrens nach Anspruch 1, bestehend aus der eigentlichen Kammer, einer in dieser befindlichen, an eine Hochspannungsquelle angeschlossenen Probenhalterung und der in dieser Kammer angeordneten bzw. an die Kammer angeflanschten Plasmaquelle, dadurch gekennzeichnet, daß die Plasmaquelle geometrisch so angeordnet bzw. gegenüber der Hochspannung abgeschirmt ist, daß der Durchgriff der Hochspannung auf die Plasmaquelle minimal ist.

5. Implantationskammer nach Anspruch 4, dadurch gekennzeichnet, daß die Abschirmung aus geerdeten, vor der Plasmaquelle aufgespannten dünnen Drähten besteht.
